Europäisches Patentamt

European Patent Office

Office européen des brevets

(19)

(11) Veröffentlichungsnummer : **0 043 508**
**B1**

(12) **EUROPÄISCHE PATENTSCHRIFT**

(45) Veröffentlichungstag der Patentschrift :
**15.08.84**

(21) Anmeldenummer : **81104915.4**

(22) Anmeldetag : **25.06.81**

(51) Int. Cl.³ : **G 03 G 15/00, G 03 B 27/58,**
**B 65 H 3/08, B 65 H 9/04,**
**B 65 H 5/08**

(54) **Vorrichtung für den Transport und die Positionierung von Druckplatten.**

(30) Priorität : **03.07.80 DE 3025201**

(43) Veröffentlichungstag der Anmeldung :
**13.01.82 Patentblatt 82/02**

(45) Bekanntmachung des Hinweises auf die Patenterteilung : **15.08.84 Patentblatt 84/33**

(84) Benannte Vertragsstaaten :
**BE DE FR GB IT NL**

(56) Entgegenhaltungen :
**EP-A- 0 000 048**
**DE-B- 2 462 216**
**US-A- 3 578 312**
**US-A- 4 002 332**

(73) Patentinhaber : **HOECHST AKTIENGESELLSCHAFT**
**Postfach 80 03 20**
**D-6230 Frankfurt am Main 80 (DE)**

(72) Erfinder : **Dennhardt, Werner**
**Kellerskopfstrasse 32**
**D-6204 Taunusstein 2 (DE)**

Jouve, 18, rue St-Denis, 75001 Paris, France

**Beschreibung**

Die Erfindung betrifft eine Vorrichtung für den Transport und die Positionierung von Druckplatten, die in einem Magazin gestapelt sind, zu einer Belichtungs- und Entwicklungsstation.

Die Herstellung von beschrifteten und bebilderten Druckplatten, die unmittelbar zum Drucken geeignet sind, geschieht in der Weise, daß diese Druckplatten zuerst elektrostatisch aufgeladen und anschließend eine Vorlage bildmäßig auf die einzelne Druckplatte projiziert wird. Nach Beendigung dieses Belichtungsvorgangs wird die Druckplatte mit einem Entwickler entwickelt, fixiert und entschichtet, wonach sie fertig für den Druck ist.

Aus der DE-PS 24 62 216 ist ein Gerät zur elektrofotografischen Herstellung von Druckformen bekannt, bei dem die einzelne Druckform von einem Stapel in einem Plattenmagazin durch eine Transportvorrichtung abgehoben wird, die aus einem Transportvorrichtung abgehoben wird, die aus einem Transportwagen mit einer Unterdrucksaugeinrichtung besteht und welche die Druckform zu einer Belichtungsbühne transportiert. Um das Aufladen der einzelnen Druckform zeitsparend mit deren Transport zu der Belichtungsbühne zu verbinden, ist eine Corona-Aufladestation für die elektrostatische Aufladung der Druckplatten an der Vorderseite des Transportwagens angeordnet und erstreckt sich quer zur Bewegungsrichtung des Transportwagens. Der Transportwagen läuft über zwei Führungsschienen und ist von einem auf der Oberseite angeordneten Motor antreibbar, der über ein Zahnrad mit einem Zahnstangentrieb im Eingriff steht, der parallel zu der Bewegungsrichtung des Transportwagens angeordnet ist. Dieser weist an der Unterseite eine Vakuumplatte auf, die über eine Anzahl von Löchern mit einer Vakuumpumpe in Verbindung steht. Beim Aufsetzen des Transportwagens auf die Oberseite der obersten Druckplatte im Plattenmagazin wird ein Unterdruck erzeugt, durch den diese Druckplatte an die Vakuumplatte angesaugt wird. Danach wird der Transportwagen mit Hilfe des Motors in Richtung der Belichtungsbühne verfahren. Sobald er seine Position oberhalb der Belichtungsbühne erreicht hat, erfolgt eine Absenkung auf die Belichtungsbühne und das Aufheben des Vakuums der Vakuumplatte, so daß die Druckplatte freigegeben und auf die Belichtungsbühne abgesetzt wird. Diese ist gleichfalls als Vakuumplatte ausgebildet und wird mit Unterdruck beaufschlagt, so daß die Druckplatte fest gegen die Belichtungsbühne gepreßt wird.

Bei diesem bekannten Gerät sind die Druckplatten im Plattenmagazin mit der fotoleitenden Schicht nach oben gestapelt und werden mit der beschichteten Seite an die Vakuumplatte des Transportwagens angesaugt. Beim Einlegen eines neuen Stapels in das Plattenmagazin oder beim Öffnen des Geräts können die im Magazin noch vorhandenen Druckplatten durch das einfallende Licht vorbelichtet werden, wodurch dann die Druckqualität der fertig entwickelten Platte leiden kann. Beim Abheben der einzelnen Druckplatte vom Stapel wird die fotoleitende beschichtete Seite der Druckplatte mit Saugeinrichtungen berührt, die zwar einen wesentlich schonenderen Transport der Druckplatte im Vergleich zu Rollen oder Bändern bei bekannten Geräten ermöglichen, jedoch können mechanische oder physikalische Fehlstellen auf der fertig entwickelten Druckplatte nicht ausgeschlossen werden.

Aus der veröffentlichten europäischen Patentanmeldung 0 000 048 ist eine Transportstation für Druckplatten bekannt, die einen Stapelbereich umfaßt, in dem sich ein Vorrat an Druckplatten befindet. Für die zwischen jeweils zwei Platten vorhandenen Papierblätter ist eine Papierablage vorhanden. Die Druckplatten werden durch einen Steuerungsmechanismus, der eine Anzahl von Saugnäpfen aufweist, vom Stapelbereich zu einem Förderband transportiert. Der Steuerungsmechanismus ist schwenkbar an einer Führungsstange befestigt, die über ein Getriebe mit einem Motor verbunden ist, um eine seitliche Gleitbewegung vor und zurück ausführen zu können. Die oberste Druckplatte wird von zumindest vier Saugnäpfen des Steuerungsmechanismus angesaugt. Dann schwenkt der Steuerungsmechanismus nach oben und gleichzeitig wird die Führungsstange mechanisch auf das Förderband hinbewegt. Wird das Vakuum in den Saugnäpfen aufgehoben, senkt sich der Steuerungsmechanismus nach unten ab und legt die Druckplatte auf dem Förderband ab. Ein zweiter Steuerungsmechanismus oberhalb des Papierzwischenblattes ergreift das Papierblatt, hebt es ab und befördert es zu der Papierablage.

Das Förderband transportiert die Druckplatte auf eine Belichtungsbühne, die eine Anzahl von Löchern in ihrer Oberfläche aufweist und eine Kammer bildet, die über eine Saugleitung mit einer Vakuumpumpe verbunden ist. Die Druckplatte wird, nachdem sie die richtige Stellung auf der Oberfläche der Belichtungsbühne eingenommen hat, durch Erzeugen eines Vakuums auf dieser festgehalten. Die Druckplatte wird mit Hilfe eines Belichtungssystems belichtet, das einen beweglichen Wagenschlitten aufweist, an dem eine Coronaaufladevorrichtung und ein Licht reflektierender Spiegel angeordnet sind. Ein Laser für die Abstrahlung von moduliertem Laserlicht ist so angeordnet, daß der von dem Laser ausgesandte Lichtstrahl von dem Spiegel abgelenkt wird und in einer Ebene etwa senkrecht zu der Oberfläche der auf der Belichtungsbühne aufliegenden Druckplatte auftrifft.

Bei dieser bekannten Vorrichtung ist die Positionierung der einzelnen Druckplatte vor dem Transport zu der Belichtungsstation und zu den übrigen Bearbeitungsstationen mit hoher Genauigkeit sowohl in Längs- als auch Querrichtung der Druckplatte nicht möglich, da hierfür keine Vorkehrungen getroffen sind. Das Entfernen der Papierzwischenlagen zwischen den Druckplatten, die im Magazin gespeichert sind, vor dem Transport zu der Belichtungsstation geschieht zeitaufwendig.

Aufgabe der Erfindung ist es, eine Vorrichtung für den Transport und die Positionierung zu schaffen, die einzelne Bearbeitungsschritte zeitlich verkürzt, das Entfernen der Papierlagen zwischen den Druckplatten im Magazin problemlos und zeitsparend gestaltet und eine Positionierung der Druckplatte sowohl in Quer- als auch in Längsrichtung mit großer Genauigkeit ermöglicht.

Diese Aufgabe wird erfindungsgemäß durch eine Vorrichtung der eingangs beschriebenen Art dadurch gelöst, daß das Magazin senkrecht zur Transportrichtung der Druckplatten ausgerichtet ist, die mit ihren unbeschichteten Seiten in Transportrichtung weisen, daß von einem verfahrbaren Hubzylinder betätigte Saugelemente die vorderste Druckplatte, die von Druckluft aus Luftdüsen auf der von einer Papierlage abgedeckten lichtempfindlichen beschichteten Seite beaufschlagt wird, erfassen und zu einer nach oben hin geöffneten Greifereinrichtung transportieren, oberhalb der zwei sich gegenüberliegende in ihrem gegenseitigen Abstand verstellbare Positioniereinheiten angeordnet sind.

In Weiterbildung der Erfindung ist das Magazin um ein Gelenk in die Horizontale schwenkbar und sind die Druckplatten mit der lichtempfindlichen Schicht nach unten in dem Magazin gestapelt. In der Vertikalstellung drückt dabei das Magazin den Plattenstapel gegen zwei horizontal ausgerichtete Abzugseinrichtungen. Jede dieser Abzugseinrichtungen besteht aus einer Führung mit mehreren Rollen, die auf einer gemeinsamen, von einem Motor angetriebenen Welle aufsitzen.

Die weitere vorteilhafte Ausgestaltung der Erfindung ergibt sich aus den Merkmalen der Ansprüche 5 bis 10.

Mit der Erfindung werden die Vorteile erzielt, daß die Druckplatten dem Magazin in Vertikalstellung entnommen werden, die das Entfernen der Papierlagen von der lichtempfindlichen beschichteten Seite der Druckplatte mit Hilfe der Druckluft aus den Düsen im Vergleich zu der Horizontalposition der Druckplatten bei der Entnahme aus dem Magazin erleichtert, daß die nach oben hin geöffnete V-förmige Greifereinrichtung in einfacher Weise für die Ausrichtung der Druckplatte in bezug auf ihre Längsrichtung sorgt und daß die beiden Positioniereinheiten eine Positionierung in Querrichtung der Druckplatte in der Größenordnung von einigen $10^{-2}$ mm ermöglichen.

Im folgenden wird die Erfindung anhand eines zeichnerisch dargestellten Ausführungsbeispiels näher beschrieben.

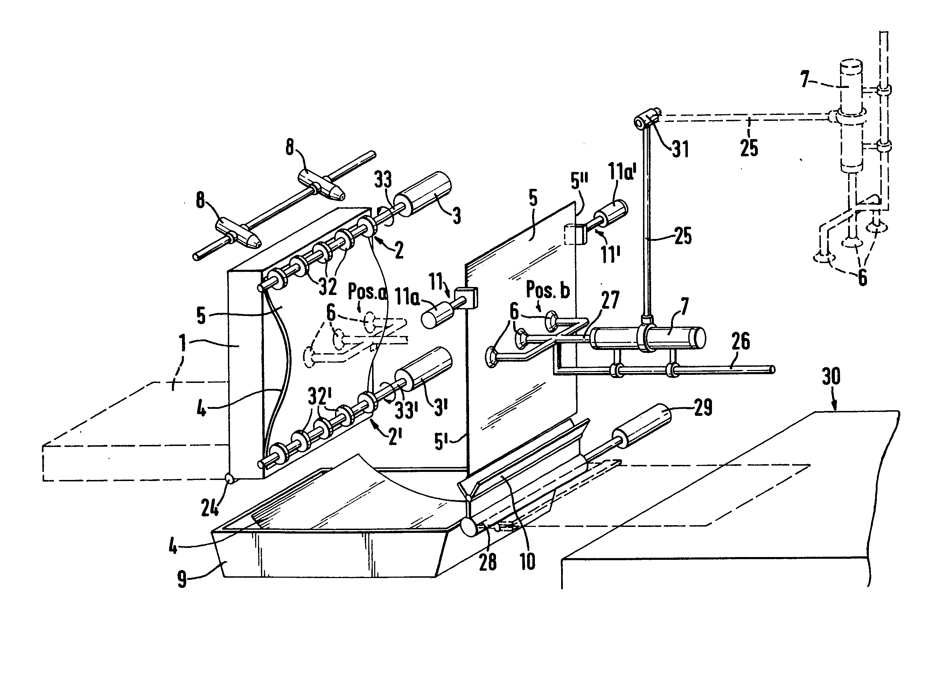

Die einzige Figur zeigt in schematischer perspektivischer Darstellung die Vorrichtung für den Transport und die Positionierung von Druckplatten 5, die in einem Magazin gespeichert sind und aus diesem Magazin zu einer Belichtungs-und Entwicklungsstation 30 transportiert werden. Die Vorrichtung umfaßt einen Hubzylinder 7, der an dem einen Ende einer schwenkbaren Stange 25 befestigt ist und durch einen Leitbügel 26 in seiner horizontalen Arbeitsstellung positioniert ist und an dessen aus- und einfahrbaren Zylinderstange 27 Saugelemente 6 angeordnet sind, ferner eine Greifereinrichtung 10 und zwei sich gegenüberliegende, in ihrem gegenseitigen Abstand verstellbare Positioniereinheiten 11, 11', die senkrecht oberhalb der Greifereinrichtung 10 angeordnet sind.

Das Magazin 1 ist um ein Gelenk 24 aus der Horizontalstellung in die Vertikalstellung schwenkbar. Zum Laden des Magazins 1 wird dieses in die horizontale Lage gekippt und ein Stapel von Druckplatten 5 so eingelegt, daß diese mit der lichtempfindlichen Schicht nach unten in dem Magazin zu liegen kommen, wodurch die Gefahr einer Vorbelichtung ausgeschlossen wird. Die Druckplatten 5 sind mit einem Blatt 4 als Zwischenlage auf ihrer lichtempfindlich beschichteten Seite versehen, wobei als Material für dieses Blatt Papier, Folien aus Kunststoff oder dergleichen Material verwendet wird. Jeweils zwischen zwei Druckplatten 5 kommt ein Blatt 4 zu liegen.

In der Vertikalstellung des Magazins 1 drückt der Plattenstapel gegen zwei federnd angeordnete Abzugseinrichtungen 2, 2', die jeweils aus einer Führung mit mehreren Rollen 32 bzw. 32' besteht. Die Rollen sitzen auf einer Welle 33 bzw. 33' auf, die von einem Motor 3 bzw. 3' angetrieben wird. Die Drehrichtung der Rollen 32 und 32' ist zueinander gegenläufig, so daß nach dem Abzug einer Druckplatte 5 aus dem Magazin 1 das Blatt 4 durch die Rollen 32 von oben nach unten und durch die Rollen 32' von unten nach oben von der lichtempfindlich beschichteten Seite der Druckplatte 5 losgelöst wird. Die gegenläufige Drehrichtung der Rollen 32 und 32' unterstützt das Abheben bzw. den Abzug der vordersten Druckplatte 5 von dem Stapel im Magazin 1.

Oberhalb des Magazins 1 in dessen Vertikalstellung befinden sich Luftdüsen 8, die schräg zur Horizontalrichtung bzw. zur Transportrichtung der Druckplatten ausgerichtet sind. Die Druckluft aus den Luftdüsen 8 löst das Blatt 4, das die lichtempfindlich beschichtete Seite der Druckplatte 5 gegen Beschädigungen schützt, von der Druckplatte 5 ab. Das Blatt 4, im allgemeinen ein Papierblatt, wird von dem Luftstrom in einen unterhalb der Transportbahn der Druckplatten liegenden Ablagebehälter 9 geblasen.

Die Luftdüsen 8 schließen gegenüber der Horizontalen einen Winkel von 15° bis 45° ein.

Die Stange 25, die an dem einen Ende den Hubzylinder 7 trägt, ist um ein Gelenk 31 verschwenkbar. In der Ruhestellung des Hubzylinders 7 ist die Stange 25 in eine Horizontallage hochgeschwenkt, die in der Zeichnung gestrichelt dargestellt ist. In der Arbeitsstellung wird die Stange 25 vertikal nach unten geschwenkt, so daß der Hubzylinder 7 zusammen mit dem Leitbügel 26 horizontal ausgerichtet ist. Die Einheit aus

Stange 25, Hubzylinder 7 und Leitbügel 26 ist horizontal verfahrbar bis zum Anliegen der Saugelemente 6, die mit der aus- und einfahrbaren Zylinderstange 27 des Hubzylinders 7 in Verbindung stehen, an der unbeschichteten Seite der vordersten Druckplatte 5 im Magazin 1.

Die Lage der Saugelemente 6 in dieser Position a ist in der Zeichnung gestrichelt dargestellt. In dieser Position werden die Saugelemente 6 zum Ansaugen und Festhalten der Druckplatte 5 mit Unterdruck beaufschlagt und die Zylinderstange 27 in den Hubzylinder 7 zum Teil eingefahren. Bei diesem Vorgang wölbt sich der mittlere, durch die Saugelemente 6 festgehaltene Abschnitt der Druckplatte 5 konvex auf, so daß die Querränder der Druckplatte 5 unter den Rollen 32, 32' der Abzugseinrichtungen 2,2' in einer Schnappbewegung der Druckplatte 5 vorbeigeführt werden. Die gegenläufige Drehung der Rollen 32, 32' unterstützt dabei den Abzug der Druckplatte 5 aus dem Magazin 1. Auf dem Weg der Druckplatte 5 von der Position a in die Position b löst der Luftstrom aus den Luftdüsen 8 das Blatt 4 von der beschichteten Seite der Druckplatte 5 und befördert das Blatt 4 in den Ablagebehälter 9. Sobald die Druckplatte 5 die Position b erreicht hat, in der sie sich oberhalb der V-förmigen Eingabeöffnung der Greifereinrichtung 10 befindet, werden in dieser Lage die Saugelemente 6, die die Druckplatte 5 festhalten, entlüftet, d. h. der Unterdruck aufgehoben, so daß die Druckplatte 5 entlang den Saugelementen 6 in die Eingangsöffnung der Greifereinrichtung 10 gleitet. Dabei drückt der Luftstrom aus den Luftdüsen 8 die Druckplatte 5 gegen die Saugelemente 6 an, wodurch ein Umkippen der Druckplatte 5 verhindert wird. Die Druckplatte 5 richtet sich in der Greifereinrichtung 10 infolge ihres Eigengewichtes in Vertikalrichtung aus.

Zum Ausrichten in Horizontal- bzw. Querrichtung sind die beiden Positioniereinheiten 11, 11' vorgesehen, von denen jede aus einer Positionierplatte und einem Motor 11a bzw. 11a' besteht. Die beiden Positioniereinheiten sind so ausgelegt, daß sie die üblichen Formate von Druckplatten und auch jede Mittenlage elektromechanisch ausrichten können. Dabei wird die Stellung der einen Positionierplatte in bekannter Weise digital vorgegeben, so daß diese Platte als feste Anschlagsfläche für die eine Kante 5' bzw. 5'' der Druckplatte dient. Wenn diese Kante der Druckplatte gegen die Positionierplatte anliegt, wird die andere Positionierplatte solange in Richtung der Anschlagsfläche verfahren, bis sie an einer der Anschlagsfläche gegenüberliegenden Kante 5'' bzw. 5' der Druckplatte 5 anliegt. Sobald es zu dieser Kontaktierung von der einen Positionierplatte über die Druckplatte 5 zu der anderen Positionierplatte gekommen ist, beendet ein dadurch ausgelöstes elektrisches Signal den Positionierungsvorgang in Horizontalrichtung. Zugleich empfängt die Greifereinrichtung 10 ein Schließsignal und hält die Druckplatte in ihrer definierten Lage fest. Die Greifereinrichtung 10 ist über eine Kupplung 28 mit einem Drehmagnet 29 verbunden, der die Greifereinrichtung 10 bei betätigter Kupplung aus der Horizontallage in die Vertikallage dreht. Sobald die Greifereinrichtung 10 die Druckplatte 5 festhält, schwenkt der Hubzylinder 7 aus der Transportbahn der Druckplatte 5 nach oben in seine horizontale Ruhestellung. Die Wirkverbindung zwischen dem Drehmagneten 29 und der Greifereinrichtung 10 wird durch Lösen der Kupplung aufgehoben, so daß die Greifereinrichtung 10 aus der Vertikalstellung in die Horizontalstellung schwenkt, wobei die Druckplatte 5 weiterhin festgehalten wird. Eine Nachlaufsteuerung, die beispielsweise digital betrieben wird, verfährt die Greifereinrichtung 10, welche die Druckplatte 5 weiterhin gefaßt hält, auf einen Saugtisch der Belichtungs- und Entwicklungsstation 30. Sobald die Endposition der Greifereinrichtung 10 auf diesem Saugtisch erreicht ist, wird die Druckplatte 5 durch den Saugtisch angesaugt. Danach öffnet die Greifereinrichtung 10 und fährt in ihre Ausgangsposition zurück. In dieser wird sie über die Kupplung 28 von dem Drehmagnet 29 nach oben gedreht, um für eine nachfolgende Druckplatte 5 aufnahmebereit zu sein. Der Hubzylinder 7 wird aus seiner Ruhestellung wieder in seine Arbeitsstellung geschwenkt, d. h. die Stange 25 ist senkrecht ausgerichtet, so daß der Transportvorgang für eine weitere Druckplatte 5 eingeleitet werden kann.

**Ansprüche**

1. Vorrichtung für den Transport und die Positionierung von Druckplatten, die in einem Magazin gestapelt sind, zu einer Belichtungs- und Entwicklungsstation, dadurch gekennzeichnet, daß das Magazin (1) senkrecht zur Transportrichtung der Druckplatten (5) ausgerichtet ist, die mit ihren unbeschichteten Seiten in Transportrichtung weisen, daß von einem verfahrbaren Hubzylinder (7) betätigte Saugelemente (6) die vorderste Druckplatte, die von Druckluft aus Luftdüsen (8) auf der von einem Blatt (4) abgedeckten lichtempfindlichen Seite beaufschlagt wird, erfassen und zu einer nach oben hin geöffneten Greifereinrichtung (10) transportieren, oberhalb der zwei sich gegenüberliegende, in ihrem gegenseitigen Abstand verstellbare Positioniereinheiten (11, 11') angeordnet sind.

2. Vorrichtung nach Anspruch 1, dadurch gekennzeichnet, daß das Magazin (1) um ein Gelenk (24) in die Horizontale schwenkbar ist, und daß die Druckplatten (5) mit der lichtempfindlichen Schicht nach unten in dem Magazin (1) gestapelt sind.

3. Vorrichtung nach Anspruch 1, dadurch gekennzeichnet, daß das Magazin (1) in der Vertikalstellung den Plattenstapel gegen zwei horizontal ausgerichtete Abzugeinrichtungen (2, 2') drückt.

4. Vorrichtung nach Anspruch 3, dadurch gekennzeichnet, daß jede Abzugseinrichtung (2; 2') aus einer Führung mit mehreren Rollen (32; 32') besteht, die auf einer gemeinsamen, von einem Motor (3, 3') angetriebenen Welle (33 ; 33') aufsitzen.

5. Vorrichtung nach den Ansprüchen 3 und 4, dadurch gekennzeichnet, daß die Abzugseinrichtungen (2, 2') nahe dem oberen und dem unteren Rand an dem Plattenstapel anliegen und daß sich die Abzugseinrichtungen gegenläufig zueinander drehen.

6. Vorrichtung nach den Ansprüchen 1 bis 5, dadurch gekennzeichnet, daß die Luftdüsen (8) oberhalb des Magazins (1) mit ihren Austrittsöffnungen nach unten geneigt angeordnet sind und gegenüber der Horizontalen einen Winkel von 15° bis 45° einschließen.

7. Vorrichtung nach Anspruch 1, dadurch gekennzeichnet, daß der Hubzylinder (7) an dem Ende einer schwenkbaren Stange (25) befestigt und durch einen Leitbügel (26) in seiner Arbeitsstellung horizontal positioniert ist und daß an der aus- und einfahrbaren Zylinderstange (27) des Hubzylinders (7) die Saugelemente (6) angeordnet sind.

8. Vorrichtung nach Anspruch 7, dadurch gekennzeichnet, daß die Stange (25) mit dem Hubzylinder (7) und dem Leitbügel (26) als Einheit horizontal verfahrbar ist.

9. Vorrichtung nach Anspruch 1, dadurch gekennzeichnet, daß jede Positioniereinheit (11 ; 11') aus einer Positionierplatte und einem Motor (11a ; 11a') zum Verfahren der Positionierplatte besteht, daß eine der beiden Positionierplatten als feste Anschlagfläche für eine Kante (5') der Druckplatte (5) in eine von dem Format der Druckplatte (5) abhängige Stellung gebracht wird und daß die andere Positionierplatte so lange in Richtung der Anschlagfläche verfährt, bis sie an der der Anschlagfläche gegenüberliegende Kante (5") der Druckplatte (5) anliegt.

10. Vorrichtung nach Anspruch 1, dadurch gekennzeichnet, daß die Greifereinrichtung (10) eine V-förmige Eingabeöffnung aufweist und über eine Kupplung (28) mit einem Drehmagnet (29) verbunden ist, der die Greifereinrichtung (10) von der Horizontalen in die Vertikale und zurück schwenkt und daß die Greifereinrichtung (10) in ihrer Horizontallage in Richtung einer Belichtungsstation (20) verfahrbar ist.

**Claims**

1. A device for transporting and for positioning printing plates which are stacked in a holder to an exposure and developing station, characterized in that the plate holder (1) is installed perpendicularly to the direction of transport of the printing plates (5), the uncoated surfaces of which point into the direction of transport, in that suction elements (6), which are actuated by a movable lifting cylinder (7), take up the first printing plate, to the light-sensitive side of which, which is covered by a sheet of paper (4) compressed air from nozzles (8) is applied, and transport it to a gripping device (10) which is open in the upward direction and above which positioning units (11, 11') are arranged opposite to one another, the mutual distance of which is adjustable.

2. A device as claimed in claim 1, characterised in that the holder (1) can be pivoted about a joint (24) into the horizontal position, and in that the printing plates (5) are stacked in the holder (1) with their light-sensitive layer pointing downwardly.

3. A device as claimed in claim 1, characterised in that the holder (1) in the vertical position presses the stack of plates against two horizontally aligned removing devices (2, 2').

4. A device as claimed in claim 3, characterised in that each removing device (2, 2') comprises a guidance with several rollers (32, 32') which are arranged on a common shaft (33, 33') driven by a motor (3, 3').

5. A device as claimed in claims 3 and 4, characterised in that the removing devices (2, 2') are in contact with the stack of plates close to the upper and to the lower edge of the stack, and in that said removing devices rotate in opposite directions to each other.

6. A device as claimed in claims 1 to 5, characterised in that the air nozzles (8) are arranged above the holder (1), with their openings being directed downwardly and including an angle of between 15° and 45° relative to the horizontal line.

7. A device as claimed in claim 1, characterised in that the lifting cylinder (7) is fastened to the end of a pivotal rod (25) and is horizontally fixed in its working position by a guide stirrup (26), and in that the suction elements (6) are arranged on the insertable and extractable cylinder rod (27) of the lifting cylinder (7).

8. A device as claimed in claim 7, characterised in that the unit formed by the rod (25) with the lifting cylinder (7) and the guide stirrup (26) can be moved horizontally.

9. A device as claimed in claim 1, characterised in that each positioning unit (11, 11') comprises a positioning plate and a motor (11a, 11a') for moving the positioning plate, in that one of the two positioning plates, serving as a fix stop surface for one edge (5') of the printing plate (5), is brought into a position depending on the size of the printing plate (5), and in that the other positioning plate is moved in the direction of the stop surface until it strikes the edge (5") of the printing plate (5), which lies opposite the stop surface.

10. A device as claimed in claim 1, characterised in that the gripping device (10) has a V-shaped feeding opening and via a coupling (28) is linked with a rotary magnet (29) by which the gripping device is swung from its horizontal position to its vertical position and back again, and in that said gripping device (10) can be moved in the direction of an exposure station (30) when it is in its horizontal position.

**Revendications**

1. Dispositif pour le transport et le positionnement de plaques d'impression qui sont empilées dans un magasin, dans un poste d'insolation et de développement, caractérisé en ce que le magasin (1) est orienté perpendiculairement à la direction du transport des plaques d'impression (5) qui présentent leurs faces non enduites dans la direction du transport, en ce que des éléments aspirants (6) actionnés par un vérin mobile (7) saisissent la plaque d'impression extrême avant, qui est soumise sur sa face photosensible recouverte d'une feuille (4) à de l'air comprimé sortant de buses d'air (8) et la transportent à un dispositif preneur (10) ouvert vers le haut, au-dessus duquel sont disposées deux dispositifs de positionnement opposées (11, 11') dont l'écartement peut être réglé.

2. Dispositif selon la revendication 1, caractérisé en ce que le magasin (1) peut pivoter jusqu'à l'horizontale autour d'une articulation (24) et en ce que les plaques d'impression (5) sont empilées dans le magasin (1) avec la couche photosensible dirigée vers le bas.

3. Dispositif selon la revendication 1, caractérisé en ce que, dans la position verticale, le magasin (1) presse la pile de plaques d'impression contre deux dispositifs d'extraction (2, 2') orientés horizontalement.

4. Dispositif selon la revendication 3, caractérisé en ce que chaque dispositif d'extraction (2, 2') est composé d'un guide muni de plusieurs galets (32, 32') qui sont montés sur un arbre commun (33, 33') entraîné par un moteur (3, 3').

5. Dispositif selon les revendications 3 et 4, caractérisé en ce que les dispositifs d'extraction (2, 2') s'appuient contre la pile de plaques à proximité du bord supérieur et du bord inférieur et en ce que les dispositifs d'extraction tournent en sens inverse l'un de l'autre.

6. Dispositif selon les revendications 1 à 5, caractérisé en ce que les buses d'air (8) sont disposées au-dessus du magasin (1) avec leurs ouvertures de sortie inclinées vers le bas et font un angle de 15° à 45° avec l'horizontale.

7. Dispositif selon la revendication 1, caractérisé en ce que le vérin (7) est fixé à l'extrémité d'une barre pivotante (25) et est placé horizontalement dans sa position de travail par un étrier de guidage (26), et en ce que les éléments aspirants (6) sont montés sur la tige de cylindre (27), mobile en extension et en retrait, du vérin (7).

8. Dispositif selon la revendication 7, caractérisé en ce que la barre (25) peut se déplacer horizontalement comme un seul bloc avec le vérin (7) et l'étrier de guidage (26).

9. Dispositif selon la revendication 1, caractérisé en ce que chaque dispositif de positionnement (11, 11') est composé d'une plaque de positionnement et d'un moteur (11a, 11a') servant à déplacer la plaque de positionnement, en ce que l'une des deux plaques de positionnement est amenée, pour servir de butée fixe pour un bord (5') de la plaque d'impression (5), dans une position qui dépend du format de la plaque d'impression (5) et en ce que l'autre plaque de positionnement est déplacée en direction de la surface de butée jusqu'à ce qu'elle s'applique contre le bord (5") de la plaque d'impression (5) qui est à l'opposé de la surface de butée.

10. Dispositif selon la revendication 1, caractérisé en ce que le dispositif preneur (10) présente une ouverture d'entrée en forme de V et est relié par un embrayage (28) à un aimant tournant (29) qui bascule le dispositif preneur (10) de l'horizontale à la verticale, et inversement, et en ce que le dispositif preneur (10) placé dans sa position horizontale peut être déplacé en direction d'un poste d'insolation (30).